# EUROPEAN PATENT SPECIFICATION

(11) **EP 4 498 131 B1**
(45) Date of publication and mention of the grant of the patent: **14.10.2026**
(21) Application number: 24189365.0
(22) Date of filing: 18.07.2024
(51) Int. Cl.: G01V 3/08, G01N 27/22, G01R 27/26

(54) **DEPLOYING ELECTRIC FIELDS**
EINSATZ ELEKTRISCHER FELDER
DÉPLOIEMENT DE CHAMPS ÉLECTRIQUES

(30) Priority: 25.07.2023 GB 202311406
(43) Date of publication of application: 29.01.2025
(73) Proprietor: Scanna MSC Limited, London W1B 2EB (GB)
(72) Inventor: CUMMINGS, Noel Samuel, London TW9 2HN (GB)
(74) Representative: Atkinson & Company Intellectual Property Limited

(56) References cited:
- GB-A- 2 583 731
- US-A1- 2014 118 635
- US-A1- 2019 220 117
- US-A1- 2022 308 702

## Description

The present invention relates to an apparatus for deploying electric fields to determine electrical characteristics, including permittivity, of an object, of the type comprising: a dielectric substrate having a first surface and a second surface; a first set of substantially parallel electrodes on said dielectric substrate; a second set of substantially parallel electrodes also on said dielectric substrate, wherein said second set of substantially parallel electrodes is substantially orthogonal to said first set of substantially parallel electrodes; first devices for energising a selected electrode of said first set of substantially parallel electrodes two or more times and sequentially monitoring two or more remaining electrodes of said first set of substantially parallel electrodes; and second devices for sequentially energising a selected electrode of said second set of substantially parallel electrodes two or more times and sequentially monitoring two or more remaining electrodes of said second set of substantially parallel electrodes.

The present invention also relates to a method of deploying electric fields to determine electrical characteristics, including permittivity, of an object, of the type in which: a dielectric substrate has a first surface and a second surface; and a first set of substantially parallel electrodes are located on said first surface.

The sensing of the electrical permittivity of an object is disclosed in US 8,994,383. A sensor is described that includes a dielectric layer that presents a surface defining the base of a volume in which a test object may be placed and an electrically active layer beneath the dielectric layer, comprising a first set of electrodes that extend in a first direction and a second set of electrodes that extend in a second direction that is perpendicular to the first direction. The electrodes are electrically isolated by deploying the first set on the first surface of the dielectric material and the second set on the second surface of the dielectric material.

By selecting one of the sets, energising a selected electrode of that set and monitoring one of the remaining electrodes of that set, data may be obtained relating to the permittivity of the material. A similar operation may be repeated during which the same electrode is energised but a different electrode is selected to be monitored; such that resulting electric fields penetrate the object to a greater or a lesser degree compared to the first iteration. GB2583731A discloses a method of examining objects using electric fields to identify regions in said object of differing permittivity/conductivity.

As described in US 10,753,898, an object can be scanned by an external electric field by placing the object on a support platform. A dielectric membrane in proximity to the support platform may include input lines and output lines, and a strobing circuit may apply input voltages to the input lines while a sampling circuit receives output voltages from the output lines.

A processing device compares selected output signals against a reference signal to produce voltage control data. A voltage adjustment circuit adjusts the input voltage from a first intensity to a second intensity in response to the voltage control data. Apparatus of this type may be deployed as a security device for scanning the shoes worn by passengers before they board an aeroplane for example.

Scanning may be performed using the first set of electrodes on the first surface of the dielectric material, followed by using the second set of electrodes mounted on the second surface of the dielectric material. However, experiment has shown that the results obtained from the two scanning procedures are different. In applications such as shoe scanning, this can create difficulties in terms of identifying the data that is actually correct. Furthermore, problems may arise in terms of adjusting input voltages if different scanning procedures are producing different results.

A known printed circuit board **A1** of a dielectric material is shown in *Figure A.* On the first surface of the circuit board **A1,** material has been etched away to reveal a first array of electrodes **A11** to **A18.** Electrodes are also etched on an underside second face of board **A1,** identified as **A19.**

Surface **A19** is also shown in *Figure A.* This includes a second array of electrodes **A21** to **A28.** The second set of electrodes **A21** to **A28** is substantially orthogonal to the first set of electrodes **A11** to **A18.**

This arrangement may be used for two-dimensional scanning, during which a selected electrode of the first set is energised and a selected electrode of the second set is monitored. This procedure is repeated for all possible electrode combinations and the results obtained may be used to present an image of an object that is being scanned. As is known in the art, this technique may be used for scanning many different objects and the present inventor has performed experiments in relation to the scanning of shoes, as worn by passengers about to enter an aeroplane or other protected area, for example.

In order to gain a better understanding of the material composition of the object under investigation, is also known to perform layering procedures with respect to a single array of electrodes. Thus, layering may be performed with respect to the first set of electrodes **A11** to **A18** and then repeated with respect to the second set of electrodes **A21** to **A28.**

A cross section of the first set of electrodes **A11** to **A18** is shown in *Figure B,* when performing a layering operation. The electrodes are mounted on the board **A1** and a ground plane **B1** is present to shield the device from external electrical noise. During a layering procedure, it is possible for the first electrode **A1** to be energised and the second electrode **A12** to be monitored. On the next cycle, the first electrode **A11** is again energised but this time the third electrode **A13** is monitored. This is followed by the first electrode **A11** being energised again with the fourth electrode **A14** being monitored. Thereafter, the first electrode **A11** is energised and the fifth electrode **A15** is monitored. As shown in *Figure B,* as the distance between the electrodes increases, the depth of penetration into the material under examination also increases.

With the object remaining in position, a similar procedure may be performed with respect to the second set of electrodes **A21** to **A28.** Thus, again, the first electrode of the second set **A21** is energised with the second electrode **A22** being monitored. The procedure is repeated with a third electrode **A23** being monitored, then the fourth electrode **A24** being monitored and the fifth electrode **A25** being monitored. Again, as the distance between the energised electrode and the monitored electrode increases, the depth of penetration also increases.

However, a problem has been identified, in that electric fields generated as a result of energising the second set of electrodes **A21** to **A28** are somewhat attenuated compared to the electric fields generated by the first set of electrodes **A11** to **A18.** As can be seen from *Figure B,* this situation can be appreciated, given that the electric fields generated by the second set of electrodes will be attracted more towards the ground plane **B1** and the electric fields must also penetrate the width of the board **A1.**

Experiments have also shown that this difference has a greater effect when the voltage of the energising electrode increases. Thus, when scanning shoes for example, it may be necessary to deploy substantially higher voltages and, in some embodiments, voltages may be increased adaptively to optimise the level of penetration. However, given the configuration described with reference to *Figure A* and *Figure B,* this optimisation can only occur with respect to the first set of electrodes **A11** to **A18** or with respect to the second set of electrodes **A21** to **A28.**

According to a first aspect of the present invention, there is provided an apparatus for deploying electric fields to determine electrical characteristics of an object, including permittivity, of the aforesaid type, characterised in that: said first set of substantially parallel electrodes are mounted on said first surface of said dielectric substrate; said second set of substantially parallel electrodes are also mounted on said first surface, thereby defining electrode crossings; discontinuities are formed in an electrode at each said electrode crossing to electrically isolate electrodes of said first set from electrodes of said second set; and an electric bridge is created at each said discontinuity, that extends away from the plane of the first surface, to maintain electrical conductivity.

In an embodiment, said electric bridge is a wire that physically passes over a continuous electrode at an electrode crossing. In an alternative embodiment, each electric bridge is formed by a respective bridge conductor on the second surface of the dielectric substrate and electrical contacts pass through the dielectric substrate, each connecting an end of a discontinuous electrode to an end of a bridge conductor.

In an embodiment, each electrode track has a normal width defining a track footprint on the dielectric substrate; and each continuous electrode at each electrode crossing has a reduced width to reveal an uncovered region of the track footprint, such that an end of a discontinuous electrodes may extend into one of said uncovered regions of a track footprint. The reduced width may define uncovered regions of track footprints with trapezoidal shapes and an end of a discontinuous electrode may have a trapezoidal shape.

According to a second aspect of the present invention, there is provided a method of the aforesaid type, characterised by: a second set of substantially parallel electrodes also located on said first surface, wherein said second set of substantially parallel electrodes is substantially orthogonal to said first set of substantially parallel electrodes thereby defining electrode crossings; discontinuities formed in an electrode at each said electrode crossing to electrically isolate electrodes of the first set from electrodes of the second set; and an electric bridge created at each said discontinuity, that extends away from the plane of the first surface, to maintain electrical continuity, and further characterised by the steps of: energising a selected electrode of said first set of substantially parallel electrodes two or more times and sequentially monitoring two or more remaining electrodes of said first set of substantially parallel electrodes; and energising a selected electrode of said second set of substantially parallel electrodes two or more times and sequentially monitoring two or more remaining electrodes of said second set of substantially parallel electrodes.

In an embodiment, a plurality of electrodes of the first set of substantially parallel electrodes are selected and sequentially energised. Thereafter, a plurality of the remaining electrodes of the first set of substantially parallel electrodes are sequentially monitored in response to respective energisations of an additional energising electrode, to produce respective output signals. In addition, a plurality of electrodes of the second set of substantially parallel electrodes may be sequentially selected and energised. Thereafter, a plurality of the remaining electrodes of said second set of substantially parallel electrodes may be monitored in response to respective energisations of an additional energising electrode, to produce respective output signals.

Embodiments of the invention will be described, by way of example only, with reference to the accompanying drawings. The detailed embodiments show the best mode known to the inventor and provide support for the invention as claimed. However, they are only exemplary and should not be used to interpret or limit the scope of the claims. Their purpose is to provide a teaching to those skilled in the art. Components and processes distinguished by ordinal phrases such as "first" and "second" do not necessarily define an order or ranking of any sort. In the drawings:
*Figure 1* shows an apparatus for deploying electric fields to determine electrical characteristics of an object;
*Figure 2* shows a first embodiment of electric bridges;
*Figure 3* shows an alternative embodiment for providing electric bridges;
*Figure 4* details the electric bridges identified in *Figure 3*;
*Figure 5* shows an alternative embodiment with electrodes of reduced width at the positions of discontinuities;
*Figure 6* shows an environment for deploying electric fields to determine electrical characteristics of an object;
*Figure 7* shows procedures performed within the environment of *Figure 6*;
*Figure 8* shows an end view of the dielectric substrate and an energization of a first electrode of a first set of substantially parallel electrodes;
*Figure 9* shows a second energization of the first electrode;
*Figure 10* shows a third energization of the first electrode;
*Figure 11* shows a fourth energization of the first electrode;
*Figure 12* shows a fifth energization of the first electrode;
*Figure 13* shows energization of a second electrode while the third electrode is monitored;
*Figure 14* shows a second energization of the second electrode;
*Figure 15* shows an alternative end view of the dielectric substrate and an energization of a first electrode of a second set of substantially parallel electrodes.

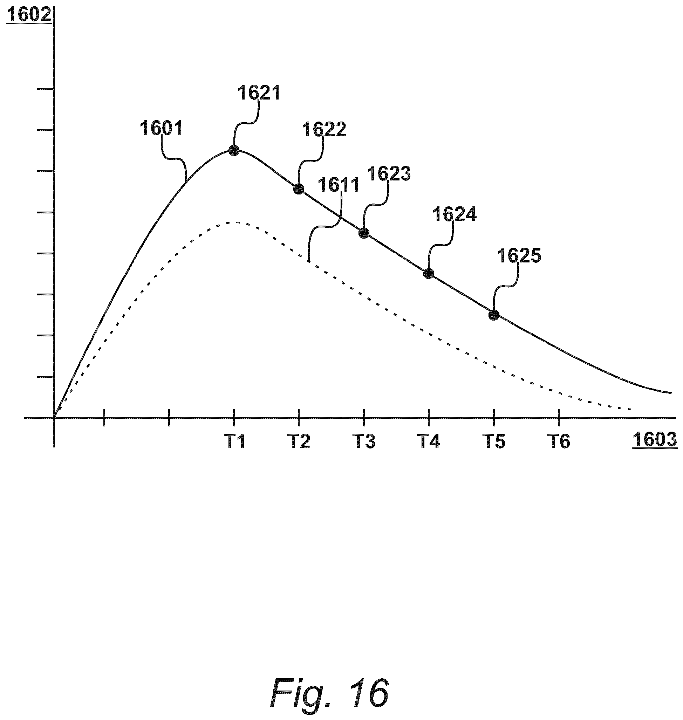

*Figure 16* shows an example of an output signal derived from a monitored electrode.

### Figure 1

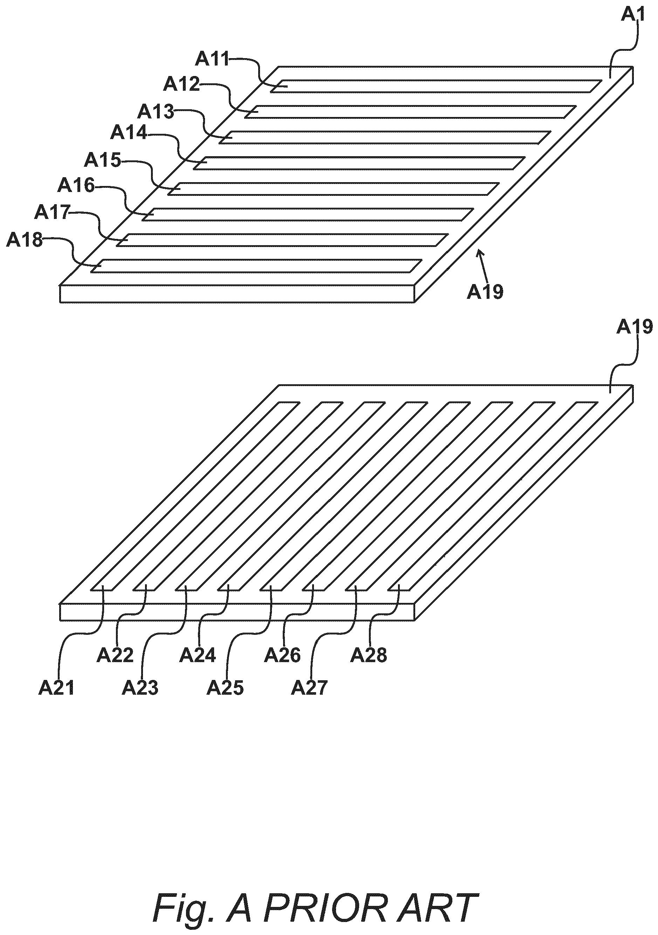

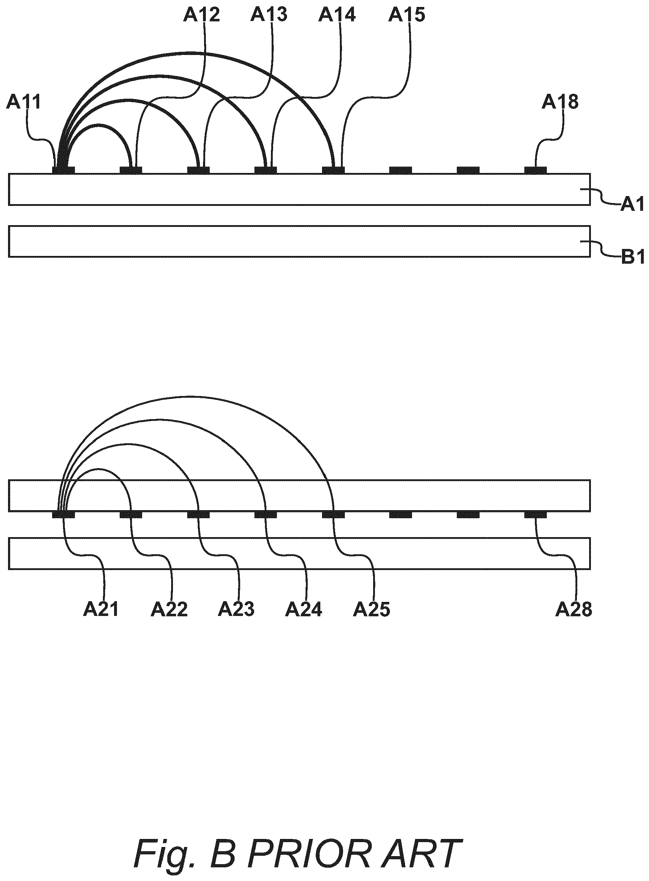

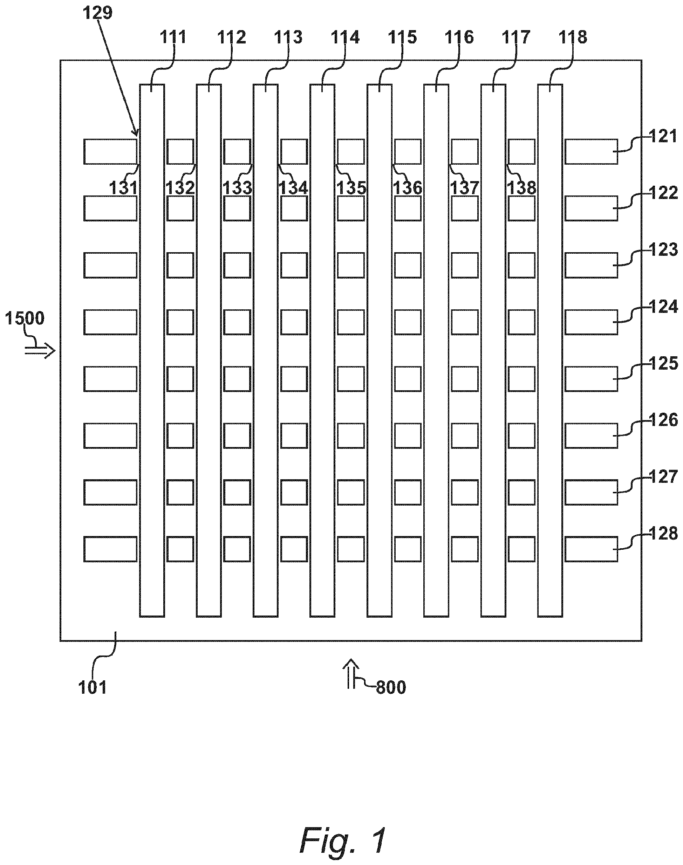

An apparatus for deploying electric fields to determine electrical characteristics of an object is shown in *Figure 1*. The apparatus includes a dielectric substrate **101** that has a first surface, as shown in *Figure 1* and a second surface obscured in *Figure 1**.*

The apparatus has a first set of substantially parallel electrodes on the first surface. The number of electrodes present will depend upon the particular application and may typically comprise four, eight or sixteen electrodes. In the embodiment shown in *Figure 1*, the first set of substantially parallel electrodes consists of eight electrodes **111** to **118.**

The apparatus also includes a second set of substantially parallel electrodes, in an arrangement similar to that described with reference to *Figure A and Figure B.* However, in the embodiment of *Figure 1*, the second set of substantially parallel electrodes is also on the first surface of the dielectric substrate **101.** In this embodiment, the second set of substantially parallel electrodes also includes eight electrodes **121** to **128.**

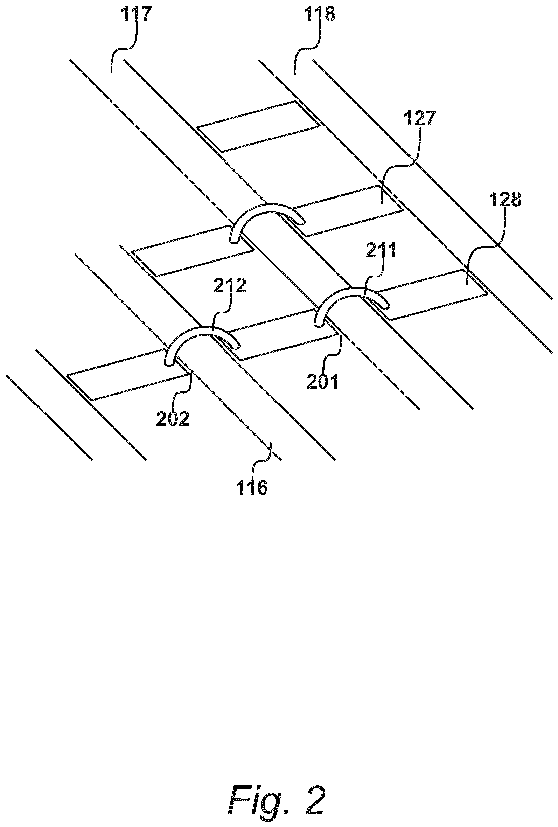

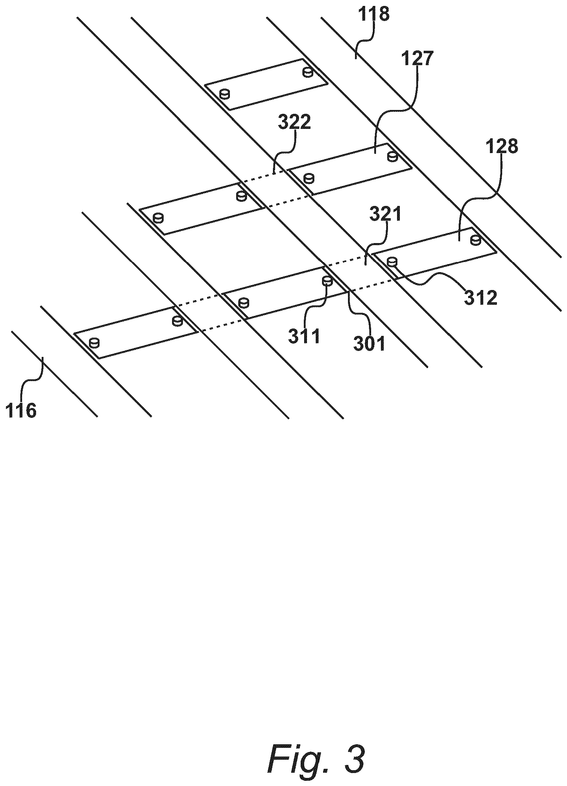

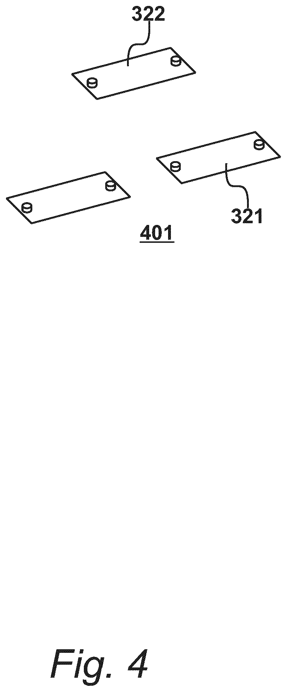

As shown in *Figure 1*, the second set of substantially parallel electrodes **(121** to **128)** is substantially orthogonal to the first set of substantially parallel electrodes **(111** to **118),** thereby defining electrode crossings, such as crossing **129,** where the first electrode **121** of the second set crosses the first electrode **111** of the first set. To allow this configuration to operate, discontinuities are formed in an electrode at each crossing, to electrically isolate an electrode of the first set from an electrode of the second set. Thus, in the embodiment of *Figure 1*, the first electrode **121** of the second set has a first discontinuity **131,** followed by a second discontinuity **132,** a third discontinuity **133,** a fourth discontinuity **134,** a fifth discontinuity **135,** a sixth discontinuity **136** a seventh discontinuity **137** and an eighth discontinuity **138.** To allow electrical connectivity to be maintained, an electric bridge is created at each discontinuity that extends away from the plane of the first surface; as described with reference to *Figure 2* and with reference to *Figure 3* and *Figure 4**.*

The dielectric substrate **101** may take the form of a board and the electrodes may be established on the board by an etching process. Alternatively, the dielectric substrate **101** may be made of a flexible acetate, having a thickness substantially less than that of a conventional printed circuit board.

The choice of dielectric material will depend upon the mechanical constraints presented within a particular application. When scanning shoes, a solid circuit board is preferred given that, when deployed, the apparatus will have to withstand the application of significant forces. In these environments, the problem described with reference to *Figure A* and *Figure B* becomes more pronounced and the deployment of the invention creates significant advantages.

### Figure 2

The sixth electrode **116,** the seventh electrode **117** and the eighth electrode **118** of the first set of substantially parallel electrodes are shown in *Figure 2**.* These are continuous electrodes and, in an embodiment, all of the discontinuities are present in the second set of electrodes. However, this arrangement is not essential and each electrode crossing may be considered independently.

In the example shown in *Figure 2*, the eighth electrode **128** of the second set has a first discontinuity **201** and a second discontinuity **202.** An electric bridge is created at each discontinuity that extends away from the plane of the first surface to maintain electrical conductivity.

In the embodiment of *Figure 2*, each bridge takes the form of a wire, such that a first wire **211** is present at the first discontinuity **201,** with a second wire **212** being present at the second discontinuity **202.** Thus, the wire physically passes over the continuous electrode at the crossing, with the first wire **211** passing over the seventh electrode **117** of the first set and the second wire **212** passing over the sixth electrode **116** of the first set.

### Figure 3

An alternative embodiment is shown in *Figure 3**,* in which each bridge is formed by a respective conductor on the second surface of the dielectric substrate (board) and electrical conductors pass through the dielectric substrate connecting ends of respective discontinuous electrodes. Thus, the eighth electrode **128** of the second array has a discontinuity **301.**

At discontinuity **301,** a first conductor **311** and a second conductor **312** penetrate the board **101** so as to emerge on the second surface of the board. Conductive tracks, comprising a first conductive track **321** and a second conductive track **322,** are etched on the second surface of the board.

### Figure 4

The second surface **401** of the dielectric substrate (board) **101** is shown in *Figure 4**.* This shows the first conductive track **321** and the second conductive track **322** providing a bridge for the seventh electrode **127** and the eighth electrode **128** of the second set respectively.

### Figure 5

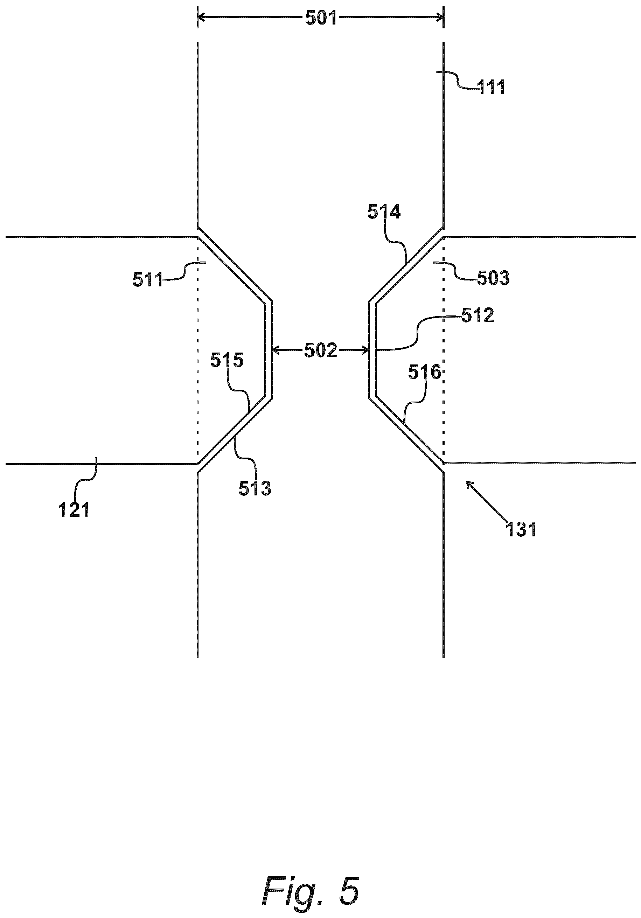

A further embodiment is illustrated in *Figure 5**,* in which each electrode, such as the first electrode **111** of the first set, has a normal width **501** defining a track footprint on the substrate **101.** However, at each discontinuity, such as at the first discontinuity **131,** the continuous electrode **111** has a reduced width **502** to reveal an uncovered region **503** of the track footprint.

In the embodiment of *Figure 5**,* the ends of the discontinuous electrodes extend into the uncovered regions **503** of the track footprints. Thus, in the embodiment of *Figure 5**,* the first discontinuous electrode **121** has a first end **511** and a second end **512.** These ends **(511, 512)** extend into the uncovered regions **503** of the track footprints.

In the embodiment of *Figure 5**,* the reduced width of the continuous electrode defines uncovered regions of the track footprints that are substantially trapezoidal in shape, as shown at **513** and **514.** Similarly, in the embodiment of *Figure 5**,* the ends of the discontinuous electrodes **(501, 512)** also have a trapezoidal shape, as illustrated at **515** and **516.**

### Figure 6

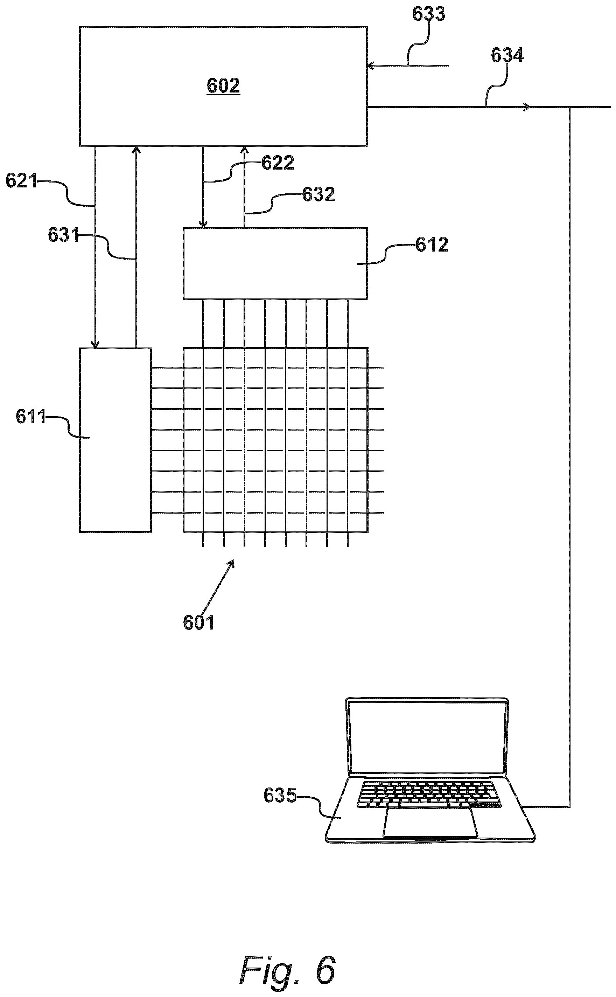

A method of deploying electric fields to determine electrical characteristics of an object may be achieved within an environment such as that shown in *Figure 6**.* The method comprises the steps of energising selected electrodes and monitoring remaining electrodes. An apparatus **601** is provided in a form substantially similar to that described with reference to *Figure 1* to *Figure 5**.* Thus, there is a dielectric substrate that has a first surface and a second surface, a first set of substantially parallel electrodes present on the first surface, and a second set of substantially parallel electrodes also present on the first surface.

The second set of substantially parallel electrodes is substantially orthogonal to the first set of substantially parallel electrodes, thereby defining electrode crossings. Discontinuities are formed in an electrode at each crossing, to electrically isolate an electrode of the first set from an electrode of the second set. Furthermore, an electric bridge is created at each discontinuity that extends away from the plane of the first surface to maintain electrical conductivity.

In the embodiment of *Figure 6**,* a processing circuit **602** communicates with the apparatus **601** via a first multiplexer **611** and a second multiplexer **612.** A first energising line **621** supplies energising signals to selected electrodes of the first set, and a second energising line **622** supplies energising signals to selected electrodes of the second set. Similarly, a first monitoring line **631** receives monitored output signals from a selected electrode of the first set, and a second monitoring line **632** receives monitored signals from a selected electrode of the second set. Thus, in this configuration, any electrode may be selected as an energised input electrode and any of the remaining electrodes may be selected as a monitored output electrode.

A power line **633** supplies power to the processing circuit **602.** Output signals from the processing circuit **602** are supplied on an output line **634,** allowing data to be analysed further by a laptop computer **635** or similar data processing device.

### Figure 7

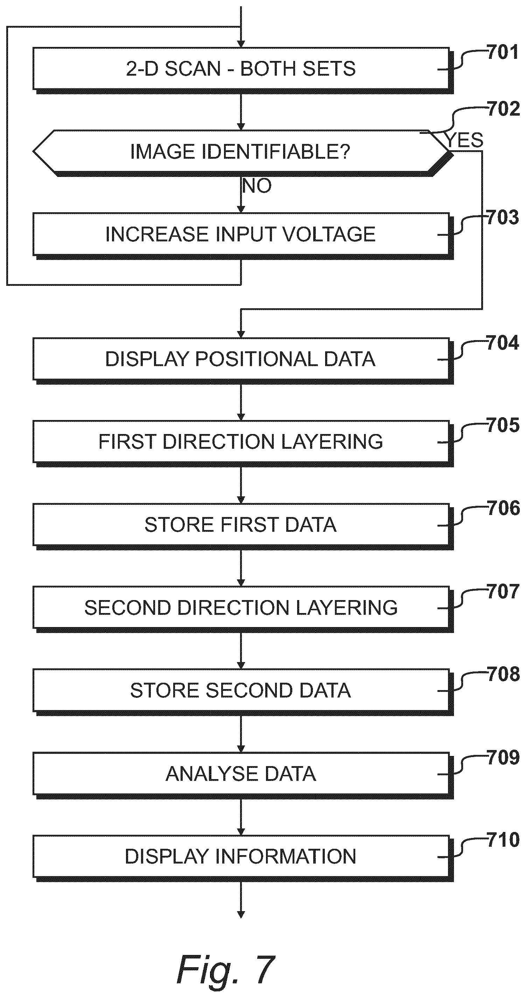

Procedures performed by the environment described with reference to *Figure 6* are shown in *Figure 7*. After an object has been placed on the apparatus, a two-dimensional scanning operation is performed at step **701** involving both sets of electrodes. Thus, an electrode of the first set is energised and an electrode of the second set is monitored. This procedure is then repeated until all possible combinations of electrodes have been considered.

In the embodiment of *Figure 7*, a question is asked at step **702** as to whether an image is identifiable. If this question is answered in the negative, it is assumed that the energising input voltage is insufficient and therefore the input voltage is increased at step **703.** The process is then repeated until the question asked at step **702** is answered in the affirmative; or a maximum energising voltage level is reached.

In response to identifying image data at step **702,** positional data is displayed at step **704.** Thus, in an embodiment, a graphical image of the shape of the object placed on the apparatus is displayed to an operative via the laptop computer **635.**

At step **705,** first direction layering is performed and the resulting data is stored at step **706.** Thereafter, second direction layering is performed at step **707,** using the second set of electrodes that are also present on the first upper surface of the dielectric substrate. In this way, the layering procedures performed at step **707** provide data that is substantially similar to the data obtained from the first direction layering procedures performed at step **705.**

At step **708,** the data derived from the second direction layering is again stored and an analysis of the stored data is performed at step **709.** This analysis may be performed by the processing circuit **602** or the analysis may be performed by the laptop computer **635.** It will also be appreciated that a further degree of analysis may take place at a remote location. At step **710,** information derived from the analysis step is displayed on the laptop computer **635.**

The apparatus may be deployed for scanning shoes to identify suspicious material. Steps **701** to **703** ensure that a sufficient degree of penetration is being achieved in order for any suspicious material to be detected if suspicious material is present. The two-dimensional scan performed at step **701** also provides a graphical image of the outline of the shoe, which can then be overlaid with the content information derived from the layering operations.

### Figure 8

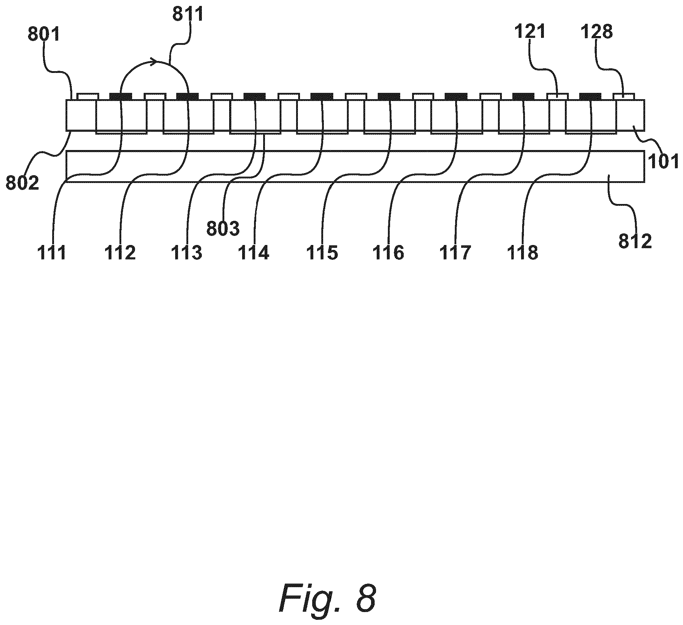

An end view of the dielectric substrate **101** is shown in Figure 8, when viewed in the direction of arrow **800** identified in *Figure 1*. One-dimensional scanning, to achieve layering, is to be performed to facilitate a method of deploying electric fields to determine electrical characteristics of an object.

The dielectric substrate **101** has a first surface **801** and a second surface **802.** The first set of substantially parallel electrodes **(111** - **118)** are located on the first surface. In this example, the first set of substantially parallel electrodes consists of eight electrodes. In alternative embodiments, fewer electrodes or more electrodes may be included to form the first set.

A second set of substantially parallel electrodes are also located on the first surface, wherein the second set of electrodes is substantially orthogonal to the first set of parallel electrodes thereby defining electrode crossings. In this embodiment, the second set of electrodes also comprises a total of eight electrodes identified as **121** to **128** as shown in *Figure 1**.*

In the view of *Figure 8**,* the first electrode **121** of the second set is visible. In this embodiment, electrodes of the second set include discontinuities at each electrode crossing to electrically isolate electrodes of the first set from electrodes of the second set. An electric bridge, such as bridge **803,** is created at each discontinuity, such as that created by the presence of electrode **113.** The bridge extends away from the plane of the first surface to maintain electrical continuity. A selected electrode of the first set is energised two or more times and two or more remaining electrodes of the first set are sequentially monitored. Subsequently, a selected electrode of the second set is energised two or more times and two or more remaining electrodes of the second set are sequentially monitored.

Any of the available electrodes may be selected to be energised and any of the remaining electrodes may be monitored. In the example shown in *Figure 8**,* this process is initiated by selecting the first electrode **111** to be energised two or more times. In this way, layering is performed because when the monitored electrode is further away from the energising electrode, the resulting electric field penetrates further into the object for which electrical characteristics are being determined. Thus, in an embodiment, this allows the electric fields to penetrate further into a shoe to determine electrical characteristics of the shoe which in turn may be interpreted to reveal the existence of prohibited matter. Thus, in the example of *Figure 8**,* the first electrode **111** of the first set is energised and the second electrode **112** is monitored, resulting in the generation of a first electric field **811.** The embodiment shown in *Figure 8* also includes a ground plane **812.**

### Figure 9

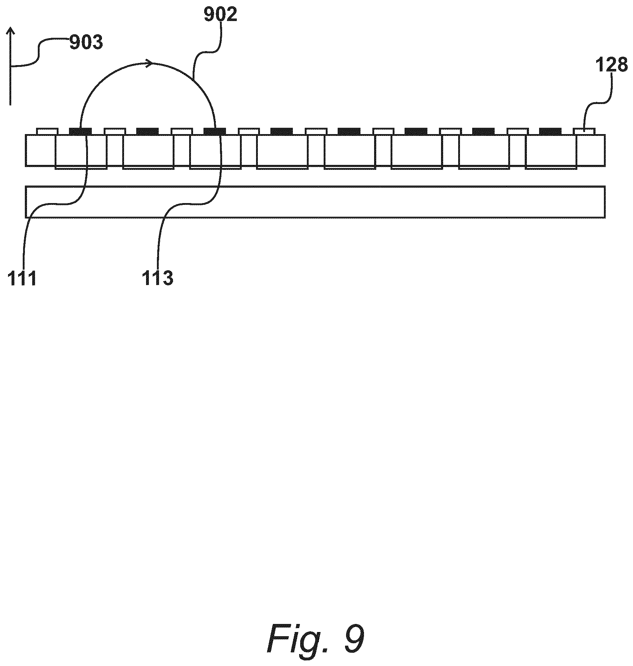

The energising of the selected electrode **111** for a second time is illustrated in *Figure 9**.* The sequential monitoring of the remaining electrodes may result in any of the remaining electrodes being monitored and it is not necessary for this sequential operation to be performed in any particular order. However, for the purposes of providing an example, in this embodiment, when the second energising operation of the first electrode **111** takes place, the third electrode **113** is monitored, resulting in the generation of a second electric field **902.** As can be seen in *Figure 9**,* the second electric field **902** exhibits greater penetration, that is in the direction of arrow **903,** compared to the penetration achieved by the first electric field **811.**

In an embodiment, only two sequential monitoring operations are performed. However, in alternative embodiments, further sequential monitoring operations may be performed to achieve a greater level of penetration.

### Figure 10

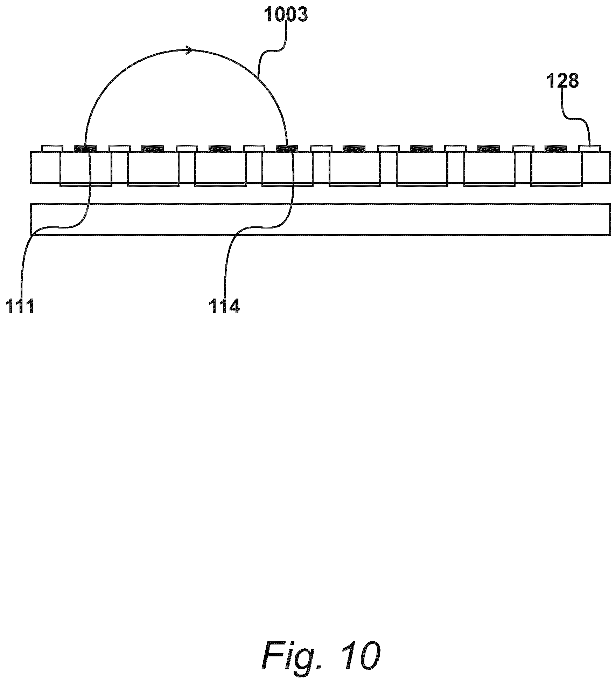

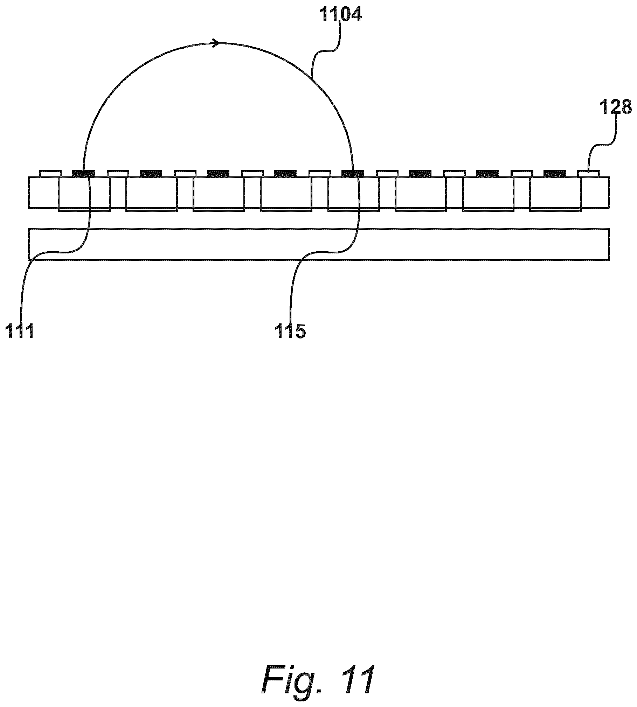

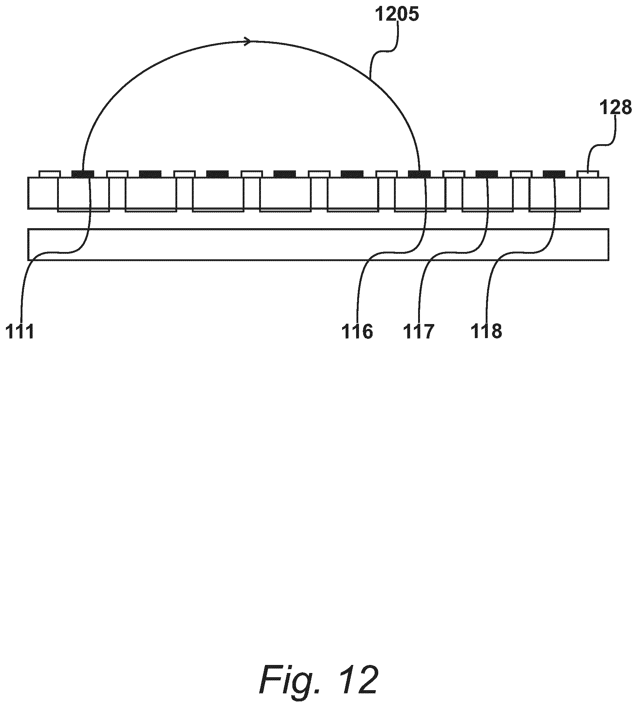

In this example, a third remaining electrode is monitored, as shown in *Figure 10**,* a fourth remaining electrode is monitored as shown in *Figure 11* and a fifth remaining electrode is monitored as shown in *Figure 12*, thereby providing greater levels of penetration. Thus, in this example, the selected electrode **111** is energised a third time and the fourth electrode **114** is monitored resulting in a third electric field **1003.**

Again, with a greater displacement between the energised electrode **111** and the monitored electrode **114,** the resulting third electric field **1003** achieves a greater level of penetration compared to the level of penetration achieved by the second electric field **902.**

### Figure 11

As illustrated in *Figure 11**,* the selected electrode **111** is energised again and the fifth electrode **115** of the remaining electrodes is monitored. This results in the generation of a fourth electric field **1104** which again achieves a greater level of penetration compared to the level of penetration achieved by the third electric field **1003.**

### Figure 12

In this embodiment, as illustrated in *Figure 12*, the selected electrode **111** is energised again and the sixth electrode **116** of the remaining eleven electrodes is monitored. This results in the generation of a fifth electric field **1205.** Again, given the greater displacement between the first electrode **111** and the sixth electrode **116,** the level of penetration achieved by the fifth electric field **1205** is greater than the level of penetration achieved by the fourth electric field **1104.**

This process could continue with the seventh electrode **117** and the eighth electrode **118** being sequentially monitored.

### Figure 13

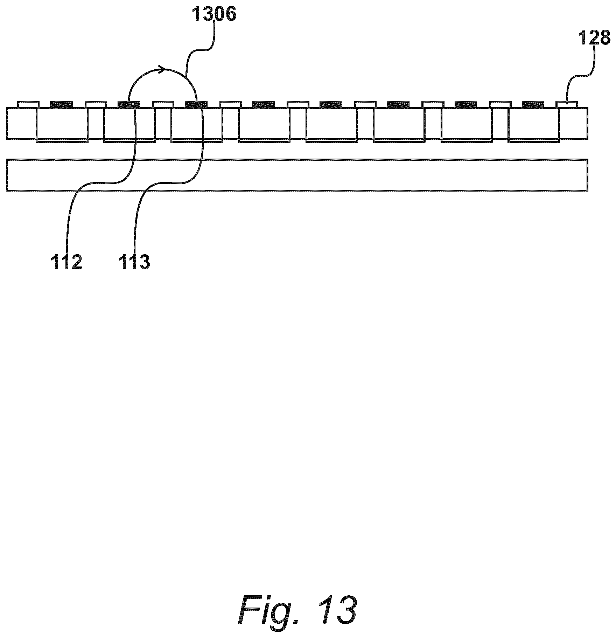

In an embodiment, it is possible for one electrode to be energised on each cycle with a plurality of electrodes being monitored to achieve the required degree of layering. However, in an alternative embodiment, as illustrated in *Figure 13*, a plurality of electrodes of the first set are selected and sequentially energised. Thus, in this embodiment, the second electrode **112** of the first set is selected and two or more of the remaining electrodes are then monitored. As shown in *Figure 13*, the second electrode **112** is energised and the third electrode **113** is monitored to produce a sixth electric field **1306.** The sixth electric field **1306** achieves a degree of penetration that is substantially similar to that achieved by the first electric field **811.** However, the position of the sixth electric field has been displaced to the right compared to the position of the first electric field **811.**

Again, the selected electrode is energised two or more times while sequentially monitoring two or more of the remaining electrodes to achieve higher degrees of penetration.

### Figure 14

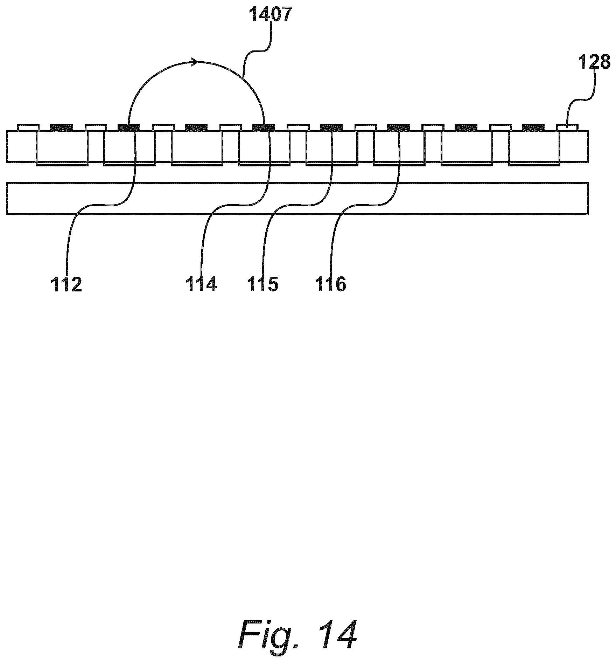

In *Figure 14*, to achieve these higher degrees of penetration, the second electrode **112** has again been energised but the fourth electrode **114** is monitored, resulting in the generation of a seventh electric field **1407.** In an embodiment, further energisations of the selected electrode take place with sequential monitoring of the fifth electrode **115** followed by the sixth electrode **116.**

### Figure 15

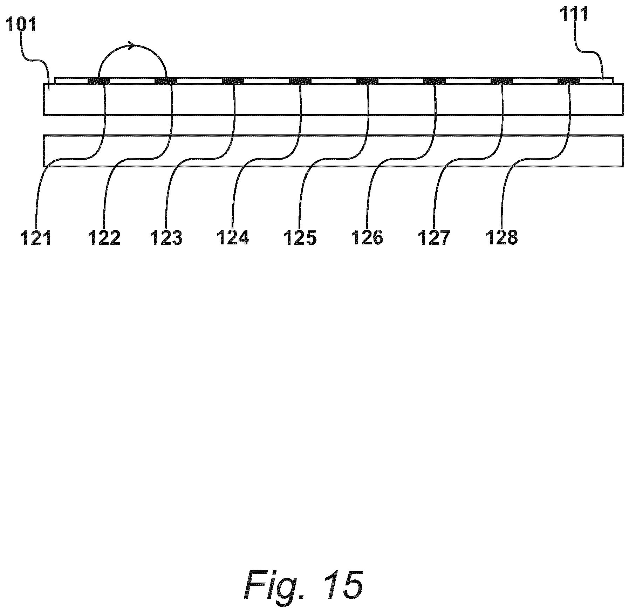

After completing the selection of electrodes of the first set of substantially parallel electrodes **111** to **118,** electrodes of the second set **121** to **128** are selected. The dielectric substrate **101** is shown in *Figure 15* when viewed in the direction of arrow **1500** identified in *Figure 1*. Thus, a selected electrode of the second set is energised two or more times and two or more remaining electrodes of the second set are sequentially monitored. The procedures performed with respect to the second set of substantially parallel electrodes is therefore substantially similar to that described with reference to *Figure 8* to *Figure 14**.*

Thus, for the purposes of illustration, as shown in *Figure 15**,* the first electrode **121** is energised and the second electrode **122** is monitored. This is then followed with the first electrode **121** being energised again and the third electrode **123** being monitored and so on to complete the cycle.

### Figure 16

An example of an output signal **1601** derived from a monitored electrode is graphically represented in *Figure 8**,* in which output voltage **1602** is plotted against time **1603.** The output signal **801** has been derived from the first array of continuous electrodes **111** to **118.**

When a similar position is monitored by the second set of discontinuous electrodes **121** to **128,** a similar response **1601** is achieved. In the earlier known configuration of electrodes, described with reference to *Figure A* and *Figure B,* a similar output signal derived from the second set of electrodes would be attenuated, as illustrated by a notional response **1611.**

To provide the first data stored at step **706** and the second data stored at step **708,** multiple samples of the monitored output signal are digitized. Thus, in an embodiment, the processing system **602** includes an analogue-to-digital converter which, for each monitored output signal, produces a first sample **1621** at time **T1,** a second sample **1622** at time **T2,** a third sample **1623** at time **T3,** a fourth sample **1624** at time **T4** and a fifth sample **1625** at time **T5.**

## Claims

1. An apparatus for deploying electric fields to determine electrical characteristics of an object, including permittivity, comprising:
a dielectric substrate (101) having a first surface and a second surface;
a first set of substantially parallel electrodes (111 - 118) on said dielectric substrate; and
a second set of substantially parallel electrodes (121 - 128) also on said dielectric substrate, wherein said second set of substantially parallel electrodes is substantially orthogonal to said first set of substantially parallel electrodes;
first devices (602, 611) for energising a selected electrode of said first set of substantially parallel electrodes two or more times and sequentially monitoring two or more remaining electrodes of said first set of substantially parallel electrodes;
second devices (602, 612) for sequentially energising a selected electrode of said second set of substantially parallel electrodes two or more times and sequentially monitoring two or more remaining electrodes of said second set of substantially parallel electrodes; and
a processing unit configured to determine the electrical characteristics;
**characterised in that**
said first set of substantially parallel electrodes are mounted on said first surface of said dielectric substrate;
said second set of substantially parallel electrodes are also mounted on said first surface of said dielectric substrate, thereby defining electrode crossings (129);
discontinuities (131, 132) are formed in an electrode at each said electrode crossing to electrically isolate electrodes of said first set from electrodes of said second set; and
an electric bridge (211, 322) is created at each said discontinuity, that extends away from the plane of the first surface, to maintain electrical conductivity.

2. The apparatus of claim **1, characterised in that** said dielectric substrate is a board and said electrodes are established on said board by an etching process.

3. The apparatus of claim **1, characterised in that** each said electric bridge is a wire (211, 212) that physically passes over a continuous electrode at an electrode crossing.

4. The apparatus of claims **1, characterised in that**:
each said bridge is formed by a respective bridge conductor (321, 322) on said second surface;
electrical contacts pass through said dielectric substrate; and
each said electrical contact connects an end of a discontinuous electrode to an end of a bridge conductor.

5. The apparatus of any of claims **1** to **4, characterised in that** all of the electrodes (111 - 118) of the first set are continuous, such that all of the discontinuities (131 - 138) are present in the second set of electrodes.

6. The apparatus of any of claims **1** to **5, characterised in that**:
each electrode track has a normal width (501) defining a track footprint on said dielectric substrate; and
each continuous electrode at each electrode crossing has a reduced track width (502) to reveal an uncovered region of the track footprint.

7. The apparatus of claim **6, characterised in that** an end (511, 503) of a discontinuous electrode extends into one of said uncovered regions of a track footprint.

8. The apparatus of claim **7, characterised in that** said reduced width defines uncovered regions of track footprints with trapezoidal shapes.

9. The apparatus of claim **8, characterised in that** an end of a said discontinuous electrode has a trapezoidal shape.

10. A method of deploying electric fields to determine electrical characteristics of an object, including permittivity, in which:
a dielectric substrate (101) has a first surface (801) and a second surface (802); and
a first set of substantially parallel electrodes (111 - 118) are located on said first surface, **characterised by**:
a second set of substantially parallel electrodes (121 - 128) also located on said first surface, wherein said second set of substantially parallel electrodes is substantially orthogonal to said first set of substantially parallel electrodes thereby defining electrode crossings;
discontinuities are formed in an electrode at each said electrode crossing to electrically isolate electrodes of the first set from electrodes of the second set; and
an electric bridge (803) is created at each said discontinuity, that extends away from the plane of the first surface, to maintain electrical continuity, and further **characterised by** the steps of:
energising a selected electrode of said first set of substantially parallel electrodes two or more times and sequentially monitoring two or more remaining electrodes of said first set of substantially parallel electrodes;
energising a selected electrode of said second set of substantially parallel electrodes two or more times and sequentially monitoring two or more remaining electrodes of said second set of substantially parallel electrodes; and
determining electrical characteristics of the object.

11. The method of claim **10, characterised by** the steps of:
selecting a plurality of electrodes of said first set of substantially parallel electrodes; and
sequentially energising said selected electrodes.

12. The method of claim **11, characterised in that** a plurality of the remaining electrodes of said first set of substantially parallel electrodes are sequentially monitored in response to respective energisations of an additional energising electrode, to produce respective output signals.

13. The method of any of claims **10** to **12, characterised by** the steps of:
selecting a plurality of electrodes of said second set of substantially parallel electrodes; and
sequentially energising said selected electrodes.

14. The method of claim **13,** wherein a plurality of the remaining electrodes of said second set of substantially parallel electrodes are monitored in response to respective energisations of an additional energising electrode, to produce respective output signals.

15. The method of any of claims **10** to **14,** further comprising the steps of:
sampling a monitored output signals a plurality of times; and
digitizing each resulting sample.

## Patentansprüche

1. Eine Vorrichtung zum Anlegen elektrischer Felder zur Bestimmung elektrischer Eigenschaften eines Objekts, einschließlich der Permittivität, die Folgendes umfasst:
ein dielektrisches Substrat (101), das eine erste Oberfläche und eine zweite Oberfläche aufweist;
einen ersten Satz im Wesentlichen paralleler Elektroden (111-118), die auf dem dielektrischen Substrat angeordnet sind; und
einen zweiten Satz im Wesentlichen paralleler Elektroden (121-128), die ebenfalls auf dem dielektrischen Substrat angeordnet sind, wobei der zweite Satz im Wesentlichen paralleler Elektroden im Wesentlichen orthogonal zu dem ersten Satz im Wesentlichen paralleler Elektroden verläuft;
eine erste Anordnung an Vorrichtungen (602, 611), die dazu dienen, eine ausgewählte Elektrode des ersten Satzes im Wesentlichen paralleler Elektroden zwei- oder mehrmals anzuregen und zwei oder mehr verbleibende Elektroden des ersten Satzes im Wesentlichen paralleler Elektroden sequenziell zu überwachen;
eine zweite Anordnung an Vorrichtungen (602, 612), die dazu dienen, eine ausgewählte Elektrode des zweiten Satzes im Wesentlichen paralleler Elektroden sequenziell zwei- oder mehrmals anzuregen und zwei oder mehr verbleibende Elektroden des zweiten Satzes im Wesentlichen paralleler Elektroden sequenziell zu überwachen; und
eine Verarbeitungseinheit, die dazu konfiguriert ist, die elektrischen Eigenschaften zu bestimmen;
**dadurch gekennzeichnet, dass**
der erste Satz im Wesentlichen paralleler Elektroden auf der ersten Oberfläche des dielektrischen Substrats angebracht ist;
der zweite Satz im Wesentlichen paralleler Elektroden ebenfalls auf der ersten Oberfläche des dielektrischen Substrats angebracht ist, wodurch Elektrodenkreuzungen (129) definiert werden;
an jeder der Elektrodenkreuzungen Unterbrechungen (131, 132) in einer Elektrode ausgebildet sind, um Elektroden des ersten Satzes von Elektroden des zweiten Satzes elektrisch zu isolieren; und
an jeder der Unterbrechungen eine elektrische Brücke (211, 322) ausgebildet ist, die sich aus der Ebene der ersten Oberfläche heraus erstreckt, um die elektrische Leitfähigkeit aufrechtzuerhalten.

2. Die Vorrichtung nach Anspruch **1**, **dadurch gekennzeichnet, dass** das dielektrische Substrat eine Platine ist und die Elektroden durch ein Ätzverfahren auf der Platine ausgebildet sind.

3. Die Vorrichtung nach Anspruch **1**, **dadurch gekennzeichnet, dass** jede elektrische Brücke ein Draht (211, 212) ist, der an einer Elektrodenkreuzung physisch über eine durchgehende Elektrode verläuft.

4. Die Vorrichtung nach Anspruch **1**, **dadurch gekennzeichnet, dass** jede Brücke durch einen jeweiligen Brückenleiter (321, 322) auf der zweiten Oberfläche gebildet wird;
elektrische Kontakte durch das dielektrische Substrat verlaufen; und jeder elektrische Kontakt ein Ende einer unterbrochenen Elektrode mit einem Ende eines Brückenleiters verbindet.

5. Die Vorrichtung nach einem der Ansprüche **1** bis **4**, **dadurch gekennzeichnet, dass** alle Elektroden (111-118) des ersten Satzes durchgehend sind, sodass sich alle Unterbrechungen (131-138) im zweiten Satz von Elektroden befinden.

6. Die Vorrichtung nach einem der Ansprüche **1** bis **5**, **dadurch**
**gekennzeichnet, dass**
jede Elektrodenbahn eine normale Breite (501) aufweist, die eine Bahnaufstandsfläche auf dem dielektrischen Substrat definiert; und
jede durchgehende Elektrode an jeder Elektrodenkreuzung eine verringerte Bahnbreite (502) aufweist, durch die ein unbedeckter Bereich der Bahnaufstandsfläche freigelegt wird.

7. Die Vorrichtung nach Anspruch **6**, **dadurch gekennzeichnet, dass** sich ein Ende (511, 503) einer unterbrochenen Elektrode in einen der unbedeckten Bereiche einer Bahnaufstandsfläche erstreckt.

8. Die Vorrichtung nach Anspruch **7**, **dadurch gekennzeichnet, dass** die verringerte Breite unbedeckte Bereiche der Bahnaufstandsflächen definiert, die eine Trapezform aufweisen.

9. Die Vorrichtung nach Anspruch **8**, **dadurch gekennzeichnet, dass** ein Ende einer der unterbrochenen Elektroden eine Trapezform aufweist.

10. Ein Verfahren zum Anlegen elektrischer Felder zur Bestimmung elektrischer Eigenschaften eines Objekts, einschließlich der Permittivität, bei dem
ein dielektrisches Substrat (101) eine erste Oberfläche (801) und eine zweite Oberfläche (802) aufweist; und
ein erster Satz im Wesentlichen paralleler Elektroden (111-118) auf der ersten Oberfläche angeordnet ist,
**dadurch gekennzeichnet, dass**
ein zweiter Satz im Wesentlichen paralleler Elektroden (121-128) ebenfalls auf der ersten Oberfläche angeordnet ist, wobei der zweite Satz im Wesentlichen paralleler Elektroden im Wesentlichen orthogonal zu dem ersten Satz im Wesentlichen paralleler Elektroden verläuft, wodurch Elektrodenkreuzungen definiert werden;
an jeder Elektrodenkreuzung Unterbrechungen in einer Elektrode ausgebildet werden, um Elektroden des ersten Satzes von Elektroden des zweiten Satzes elektrisch zu isolieren; und
an jeder Unterbrechung eine elektrische Brücke (803) ausgebildet wird, die sich aus der Ebene der ersten Oberfläche heraus erstreckt, um die elektrische Kontinuität aufrechtzuerhalten,
und ferner **dadurch gekennzeichnet, dass**
eine ausgewählte Elektrode des ersten Satzes im Wesentlichen paralleler Elektroden zwei- oder mehrmals angeregt wird und zwei oder mehr verbleibende Elektroden des ersten Satzes im Wesentlichen paralleler Elektroden sequenziell überwacht werden;
eine ausgewählte Elektrode des zweiten Satzes im Wesentlichen paralleler Elektroden zwei- oder mehrmals angeregt wird und zwei oder mehr verbleibende Elektroden des zweiten Satzes im Wesentlichen paralleler Elektroden sequenziell überwacht werden; und
die elektrischen Eigenschaften des Objekts bestimmt werden.

11. Das Verfahren nach Anspruch **10**, **dadurch gekennzeichnet, dass** mehrere Elektroden des ersten Satzes im Wesentlichen paralleler Elektroden ausgewählt werden; und
die ausgewählten Elektroden sequenziell angeregt werden.

12. Das Verfahren nach Anspruch **11**, **dadurch gekennzeichnet, dass** mehrere der verbleibenden Elektroden des ersten Satzes im Wesentlichen paralleler Elektroden als Reaktion auf die jeweilige Anregung einer zusätzlichen Anregungselektrode sequenziell überwacht werden, um entsprechende Ausgangssignale zu erzeugen.

13. Das Verfahren nach einem der Ansprüche **10** bis **12**, **dadurch**
**gekennzeichnet, dass**
mehrere Elektroden des zweiten Satzes im Wesentlichen paralleler Elektroden ausgewählt werden; und
die ausgewählten Elektroden sequenziell angeregt werden.

14. Das Verfahren nach Anspruch **13**, wobei mehrere der verbleibenden Elektroden des zweiten Satzes im Wesentlichen paralleler Elektroden als Reaktion auf die jeweilige Anregung einer zusätzlichen Anregungselektrode überwacht werden, um entsprechende Ausgangssignale zu erzeugen.

15. Das Verfahren nach einem der Ansprüche **10** bis **14**, das ferner die folgenden Schritte umfasst:
mehrmaliges Abtasten eines überwachten Ausgangssignals; und
Digitalisieren jeder daraus resultierenden Abtastung.

## Revendications

1. Appareil d'application de champs électriques destiné à déterminer des caractéristiques électriques d'un objet, notamment sa permittivité, comprenant :
un substrat diélectrique (101) présentant une première face et une seconde face ; un premier ensemble d'électrodes sensiblement parallèles (111 à 118) sur ledit substrat diélectrique ; et
un second ensemble d'électrodes sensiblement parallèles (121 à 128) également sur ledit substrat diélectrique, ledit second ensemble d'électrodes sensiblement parallèles étant sensiblement orthogonal audit premier ensemble d'électrodes sensiblement parallèles ;
des premiers dispositifs (602, 611) pour réaliser au moins deux excitations d'une électrode sélectionnée dudit premier ensemble d'électrodes sensiblement parallèles et contrôler successivement au moins deux électrodes restantes dudit premier ensemble d'électrodes sensiblement parallèles ;
des seconds dispositifs (602, 612) pour réaliser successivement au moins deux excitations d'une électrode sélectionnée dudit second ensemble d'électrodes sensiblement parallèles et contrôler successivement au moins deux électrodes restantes dudit second ensemble d'électrodes sensiblement parallèles ; et
une unité de traitement configurée pour déterminer les caractéristiques électriques ; **caractérisé en ce que** :
les électrodes dudit premier ensemble d'électrodes sensiblement parallèles sont montées sur ladite première face dudit substrat diélectrique ;
les électrodes dudit second ensemble d'électrodes sensiblement parallèles sont également montées sur ladite première face dudit substrat diélectrique, définissant ainsi des croisements d'électrodes (129) ;
des discontinuités (131, 132) sont formées dans une électrode au niveau de chacun desdits croisements d'électrodes afin d'isoler électriquement les électrodes dudit premier ensemble des électrodes dudit second ensemble ; et
un pont électrique (211, 322) est créé au niveau de chacune desdites discontinuités, ledit pont s'étendant hors du plan de la première face afin de maintenir la conductivité électrique.

2. Appareil selon la revendication **1**, **caractérisé en ce que** ledit substrat diélectrique est une carte et **en ce que** lesdites électrodes sont formées sur ladite carte par un procédé de gravure.

3. Appareil selon la revendication **1**, **caractérisé en ce que** chacun desdits ponts électriques est un fil (211, 212) qui passe physiquement au-dessus d'une électrode continue au niveau d'un croisement d'électrodes.

4. Appareil selon la revendication **1**, **caractérisé en ce que** :
chacun desdits ponts est formé par un conducteur de pont respectif (321, 322) sur ladite seconde face ;
des contacts électriques traversent ledit substrat diélectrique ; et
chacun desdits contacts électriques relie une extrémité d'une électrode discontinue à une extrémité d'un conducteur de pont.

5. Appareil selon l'une quelconque des revendications **1** à **4**, **caractérisé en ce que** toutes les électrodes (111 à 118) du premier ensemble sont continues, de sorte que toutes les discontinuités (131 à 138) sont présentes dans le second ensemble d'électrodes.

6. Appareil selon l'une quelconque des revendications **1** à **5**, **caractérisé en ce que** :
chaque piste d'électrode présente une largeur normale (501) définissant une empreinte de piste sur ledit substrat diélectrique ; et
chaque électrode continue présente, au niveau de chaque croisement d'électrodes, une largeur de piste réduite (502) faisant apparaître une région non recouverte de l'empreinte de piste.

7. Appareil selon la revendication **6**, **caractérisé en ce qu'**une extrémité (511, 503) d'une électrode discontinue s'étend dans l'une desdites régions non recouvertes d'une empreinte de piste.

8. Appareil selon la revendication **7**, **caractérisé en ce que** ladite largeur réduite définit des régions non recouvertes d'empreintes de piste présentant une forme trapézoïdale.

9. Appareil selon la revendication **8**, **caractérisé en ce qu'**une extrémité de ladite électrode discontinue présente une forme trapézoïdale.

10. Procédé d'application de champs électriques destiné à déterminer des caractéristiques électriques d'un objet, notamment sa permittivité, dans lequel :
un substrat diélectrique (101) présente une première face (801) et
une seconde face (802) ; et
un premier ensemble d'électrodes sensiblement parallèles (111 à 118) est situé sur ladite première face, **caractérisé en ce que** :
un second ensemble d'électrodes sensiblement parallèles (121 à 128) est également situé sur ladite première face, ledit second ensemble d'électrodes sensiblement parallèles étant sensiblement orthogonal audit premier ensemble d'électrodes sensiblement parallèles, définissant ainsi des croisements d'électrodes ;
des discontinuités sont formées dans une électrode au niveau de chacun desdits croisements d'électrodes afin d'isoler électriquement les électrodes du premier ensemble des électrodes du second ensemble ; et
un pont électrique (803) est créé au niveau de chacune desdites discontinuités, ledit pont s'étendant hors du plan de la première face afin de maintenir la continuité électrique, et **caractérisé en outre par** les étapes consistant à :
exciter au moins deux fois une électrode sélectionnée dudit premier ensemble d'électrodes sensiblement parallèles et contrôler successivement au moins deux électrodes restantes dudit premier ensemble d'électrodes sensiblement parallèles ; exciter au moins deux fois une électrode sélectionnée dudit second ensemble d'électrodes sensiblement parallèles et contrôler successivement au moins deux électrodes restantes dudit second ensemble d'électrodes sensiblement parallèles ; et
déterminer les caractéristiques électriques de l'objet.

11. Procédé selon la revendication **10**, **caractérisé par** les étapes consistant à :
sélectionner une pluralité d'électrodes dudit premier ensemble d'électrodes sensiblement parallèles ; et
exciter successivement lesdites électrodes sélectionnées.

12. Procédé selon la revendication **11**, **caractérisé en ce qu'**une pluralité des électrodes restantes dudit premier ensemble d'électrodes sensiblement parallèles sont contrôlées successivement en réponse aux excitations respectives d'une électrode d'excitation supplémentaire, afin de produire des signaux de sortie respectifs.

13. Procédé selon l'une quelconque des revendications **10** à **12**, **caractérisé par** les étapes consistant à :
sélectionner une pluralité d'électrodes dudit second ensemble d'électrodes sensiblement parallèles ; et
exciter successivement lesdites électrodes sélectionnées.

14. Procédé selon la revendication **13**, dans lequel une pluralité des électrodes restantes dudit second ensemble d'électrodes sensiblement parallèles sont contrôlées en réponse aux excitations respectives d'une électrode d'excitation supplémentaire, afin de produire des signaux de sortie respectifs.

15. Procédé selon l'une quelconque des revendications **10** à **14**, comprenant en outre les étapes consistant à :
échantillonner plusieurs fois un signal de sortie contrôlé ; et
numériser chaque échantillon obtenu.
